(19)

Europäisches Patentamt

European Patent Office

Office européen des brevets

(11) **EP 4 502 759 A1**

(12) **EUROPEAN PATENT APPLICATION**

(43) Date of publication:
**05.02.2025 Bulletin 2025/06**

(21) Application number: **24190831.8**

(22) Date of filing: **25.07.2024**

(51) International Patent Classification (IPC):
*G06F 1/26* (2006.01)

(52) Cooperative Patent Classification (CPC):
**G06F 1/26**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **03.08.2023 JP 2023127326**

(71) Applicant: **CANON KABUSHIKI KAISHA
Tokyo 146-8501 (JP)**

(72) Inventor: **HASEGAWA, Takashi
Tokyo, 146-8501 (JP)**

(74) Representative: **TBK
Bavariaring 4-6
80336 München (DE)**

(54) **ELECTRONIC APPARATUS, CONTROL METHOD, STORAGE MEDIUM AND PROGRAM**

(57) An electronic apparatus operates using power received from a power supply device (200), and comprises a connection unit (107) configured to connect with the power supply device, and a control unit (101, 300) configured to obtain first remaining amount information related to power that can be supplied from the power supply device, calculate second remaining amount information related to power by which the electronic apparatus is operable based on the first remaining amount information, and display the second remaining amount information. The control unit switches a display precision of the second remaining amount information based on a reliability of the first remaining amount information obtained from the power supply device.

F I G. 3

EP 4 502 759 A1

# Description

BACKGROUND OF THE INVENTION

Field of the Invention

The present invention relates to control for displaying an operable time of an electronic apparatus.

Description of the Related Art

A Universal Serial Bus (USB) Power Delivery (PD) standard is a standard in which power can be supplied by connecting a power supply device and a power receiving device by USB Type-C standard connectors and cable. In the USB PD standard, by performing communication (CC communication) via configuration channel (CC) terminals of USB Type-C connectors, a power supply device (source device) and a power receiving device (sink device) detect connection between the devices, perform negotiation related to power supply and power reception, and exchange information such as a battery remaining amount.

The power supply device is a mobile battery or the like, and the power receiving device is a digital camera or the like. The power receiving device operates using power supplied from the power supply device connected by the USB Type-C connectors. The power receiving device calculates information such as an operable time using power supplied from the power supply device based on remaining amount information of a battery obtained from the power supply device and displays the information.

However, since precision and reliability of the battery remaining amount information obtained from the power supply device are different depending on a revision of a standard of communication with the power supply device, precision and reliability of information such as the operable time of the power receiving device calculated from the battery remaining amount information obtained from the power supply device are also different. Even though the precision and reliability of the battery remaining amount information obtained from the power supply device are thus different, when a precision at the time of displaying information such as the operable time calculated by the power receiving device is the same, a user cannot recognize a difference in the precision and reliability of the information such as the operable time and thus cannot perform appropriate preparations.

SUMMARY OF THE INVENTION

The present invention has been made in consideration of the aforementioned problems, and realizes techniques that allow a user to recognize a difference in precision and reliability of information on a remaining amount of power that can be supplied from a power supply device when the power supply device is connected to a power receiving device.

In order to solve the aforementioned problems, the present invention provides an electronic apparatus as specified in claims 1 to 11.

In order to solve the aforementioned problems, the present invention provides a control method of an electronic apparatus as specified in claim 12.

In order to solve the aforementioned problems, the present invention provides a computer-readable storage medium as specified in claim 13.

In order to solve the aforementioned problems, the present invention provides a program as specified in claim 14.

According to the present invention, a user can recognize a difference in precision and reliability of information on a remaining amount of power that can be supplied from a power supply device.

Further features of the present invention will become apparent from the following description of exemplary embodiments (with reference to the attached drawings).

BRIEF DESCRIPTION OF THE DRAWINGS

FIG. 1 is a block diagram illustrating a hardware configuration of a power receiving device according to the present embodiment.
FIG. 2 is a block diagram illustrating detailed hardware configurations of a power supply device and the power receiving device according to the present embodiment.
FIG. 3 is a functional block diagram of a display control unit according to the present embodiment.
FIGS. 4A1, 4A2, 4B1, 4B2, 4C1, and 4C2 are diagrams illustrating examples of display of an operable time in the power receiving device according to the present embodiment.
FIG. 5 is a flowchart illustrating display control processing according to the present embodiment.

DESCRIPTION OF THE EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

Regarding the present embodiment, a power receiving device obtains first remaining amount information related to power that can be supplied from the power supply device, calculates second remaining amount information related to power by which the power receiving device is operable based on the first remaining amount information, and displays the second remaining amount information. At this time, the power receiving device switches a display precision of the second remaining amount information based on a reliability of the first remaining amount information obtained from the power supply device. This makes it possible for a user to recognize a difference in the reliability of the first remaining amount information obtained from the power supply device and the reliability of the second remaining amount information calculated from the first remaining amount information and perform appropriate preparations, thereby reducing situations such as that in which operation is inadvertently restricted. The appropriate preparations are, for example, preparing a mobile battery for replacement and changing operation mode of the power receiving device to low-power mode.

In the present embodiment, an example in which an electronic apparatus is applied to an image capture apparatus, such as a digital camera capable of capturing a still image and a moving image will be described. The image capture apparatus may be any device so long as it can be operated as a digital camera and may be a smartphone, a tablet, an industrial camera, a medical camera, or the like.

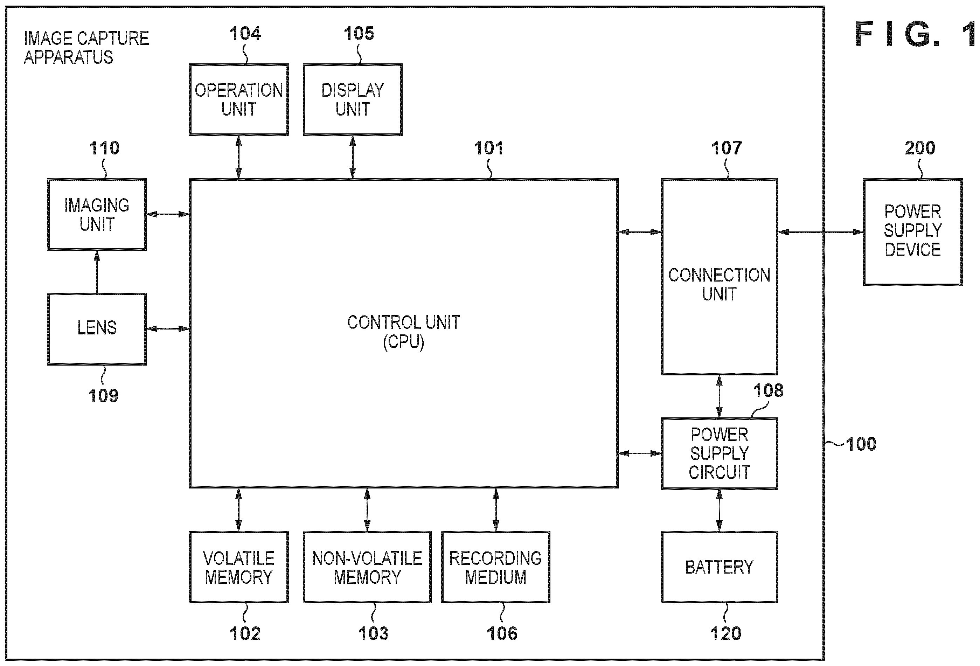

First, configurations and functions of the power supply device and the power receiving device according to the present embodiment will be described with reference to FIGS. 1 to 3.

FIG. 1 is a block diagram illustrating a hardware configuration of the power receiving device according to the present embodiment.

The power receiving device according to the present embodiment is an image capture apparatus 100.

A control unit 101 includes a processor (CPU) that performs computational processing and control processing of the image capture apparatus 100 and, by executing a control program stored in a non-volatile memory 103, controls each component of the image capture apparatus 100.

A volatile memory 102 is a RAM. Regarding the volatile memory 102, constants, variables, and control programs read from the non-volatile memory 103 for operation of the control unit 101, and the like are loaded. The volatile memory 102 stores image data received from an external device by a connection unit 107 and image data obtained by an imaging unit 110.

The non-volatile memory 103 is an electrically erasable and recordable EEPROM, flash memory, or the like. The non-volatile memory 103 stores constants, control programs, and the like for the operation of the control unit 101. Further, the non-volatile memory 103 stores information related to power consumption corresponding to operation mode of the image capture apparatus 100, a table for reference for determining a revision of a communication standard for communicating with an external device, and the like.

An operation unit 104 is an operation member, such as various types of switches, buttons, and a touch panel, that receives various operations from the user and notifies the control unit 101. The operation unit 104 also provides a user interface for the user to operate the image capture apparatus 100.

A display unit 105 displays a live view image, a captured image, text for interactive operation, operation mode of the image capture apparatus 100, and the like. The display unit 105 displays remaining amount information of a battery 120 mounted on the image capture apparatus 100 and a time for which the image capture apparatus 100 is operable based on remaining amount information of a battery 214 of a power supply device 200 connected to the image capture apparatus 100. The display unit 105 is, for example, a display device such as a liquid crystal display or an organic EL display. The display unit 105 may be configured to be integrated with the image capture apparatus 100 or may be an external device connected to the image capture apparatus 100.

A recording medium 106 is, for example, a memory card or a hard disk to and from which data can be written and read by the control unit 101. The recording medium 106 stores image files, control programs, and the like.

The connection unit 107 is an interface for connecting with an external device such as the power supply device 200 according to the present embodiment. The image capture apparatus 100 is connected with the external device via the connection unit 107 so as to be capable of communication and power reception. The connection unit 107 is an interface conforming to, for example, a Universal Serial Bus (USB) standard, in particular, USB Type-C and USB Power Delivery (PD) standards. By controlling the connection unit 107, the image capture apparatus 100 can perform communication and power reception conforming to the USB PD standard with an external device.

The connection unit 107 is not limited to being an interface conforming to the USB standard and may be an interface capable of communication and power reception using another method.

The power supply device 200 according to the present embodiment is a charger such as a mobile battery and includes a communication function and a power supply function conforming to the Universal Serial Bus (USB) standard, in particular, the USB Type-C and USB PD standards. The power supply device 200 is not limited to being a mobile battery and may be a personal computer (PC) or the like including a rechargeable battery.

A power supply circuit 108 can receive power from the battery 120 mounted on the image capture apparatus 100 and charge the battery 120. The battery 120 is a primary battery, such as an alkaline battery or a lithium battery, or a rechargeable secondary battery, such as a NiCd battery, a NiMH battery, or a lithium-ion battery. The battery 120 can be attached to and detached from the image capture apparatus 100 and can supply power to the image capture apparatus 100.

The power supply circuit 108 converts the voltage of power supplied from the battery 120 or the power supply device 200 via the connection unit 107 to a voltage at which each component of the image capture apparatus 100 is operable.

An image capture lens (lens unit) 109 includes a lens group (not illustrated) (including a zoom lens, a focus lens, and the like), a lens drive unit (not illustrated), a diaphragm (not illustrated), and the like and forms an optical image of a subject on an imaging surface of the imaging unit 110.

The imaging unit 110 includes an image sensor constituted by a charge-coupled device (CCD), a complementary metal-oxide semiconductor (CMOS) device, or the like and converts an optical image of a subject into an electric signal.

The control unit 101 performs various kinds of image processing on image data captured by the imaging unit 110, generates an image file (e.g., still image or moving image), and displays the image file on the display unit 105 or stores the image file in the recording medium 106. The control unit 101 performs predetermined computational processing using the image data captured by the imaging unit 110 and performs exposure control and ranging control based on a computation result.

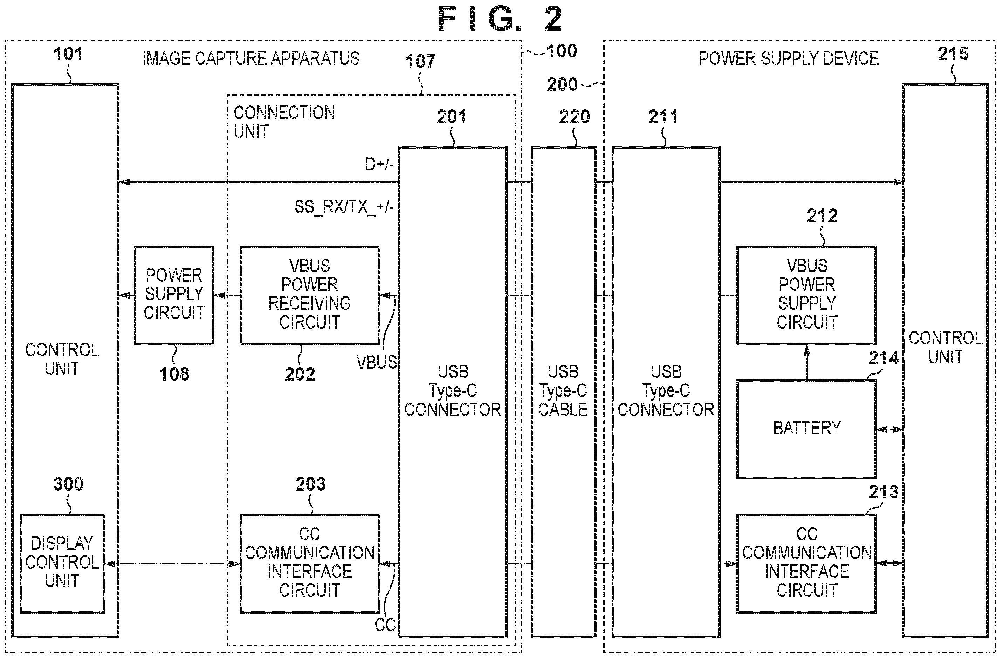

Next, a connection configuration of the image capture apparatus 100 and the power supply device 200 will be described with reference to FIG. 2.

The image capture apparatus 100 is physically and electrically connected with the power supply device 200 by a USB Type-C cable 220 and can communicate and receive power.

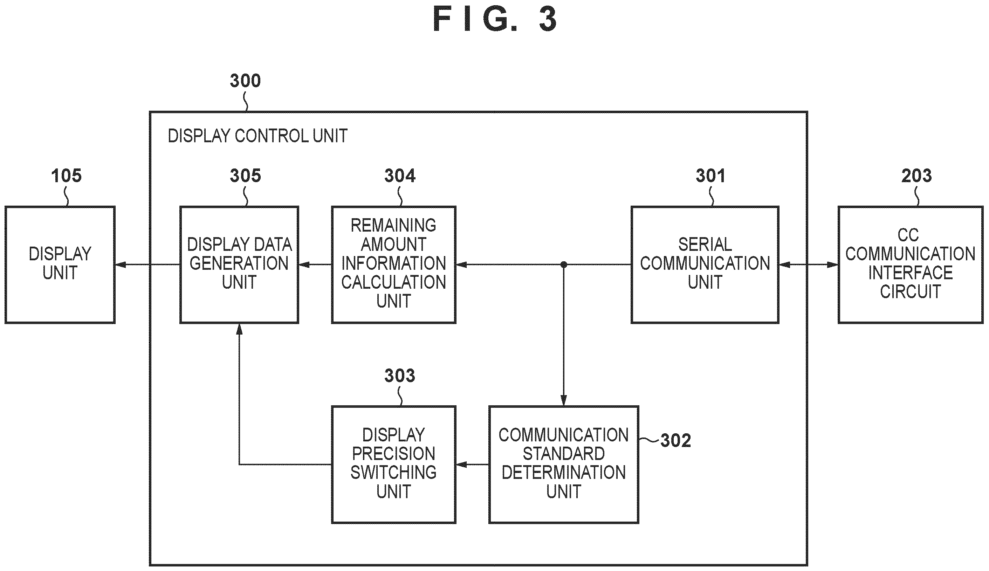

The control unit 101 includes a display control unit 300, which performs control for displaying the second remaining amount information according to the present embodiment. A configuration of the display control unit 300 will be described later in detail in FIG. 3.

The connection unit 107 includes a USB connector 201, a VBUS power receiving circuit 202, and a CC communication interface circuit 203. The USB connector 201 and a USB connector 211, which will be described later, are USB Type-C connectors to which the USB Type-C cable 220 can be connected. A USB Type-C connector includes a D+/D- terminal and an SS+/SS- terminal of a data communication line, a GND terminal of a GND signal (not illustrated), a VBUS terminal of a power supply line, and a configuration channel (CC) terminal. The CC terminal is a terminal conforming to the USB Type-C and USB PD standards.

The VBUS power receiving circuit 202 is constituted by a DCDC converter or the like for converting a VBUS voltage supplied from the power supply device 200 to the voltage of a system power of the image capture apparatus 100. The power supply circuit 108 supplies power for which the voltage has been converted in the VBUS power receiving circuit 202 to each unit of the image capture apparatus 100. The image capture apparatus 100 operates using power supplied from the power supply circuit 108. The CC communication interface circuit 203 is connected to a CC communication interface circuit 213 of the power supply device 200 via the CC terminal of the USB connector 201 and is configured by a dedicated IC for CC communication, for example.

The power supply device 200 is a mobile battery conforming to the USB Type-C and USB PD standards. The power supply device 200 includes the USB connector 211, a VBUS power supply circuit 212, the CC communication interface circuit 213, the battery 214, and a control unit 215.

The VBUS power supply circuit 212 is configured by a DCDC converter or the like for generating a VBUS voltage from an electromotive force of the battery 214 of the power supply device 200. The battery 214 is built-in in order to supply power for the power supply device 200 to operate and is constituted by a lithium-ion battery or the like. The USB connector 211 and the CC communication interface circuit 213 are similar to the USB connector 201 and the CC communication interface circuit 203, respectively.

The control unit 215 includes a processor (CPU) that performs computational processing and control processing of the power supply device 200 and a memory and, by executing a control program stored in the memory, controls each component of the power supply device 200.

The control unit 215 performs power supply negotiation conforming to the USB PD standard and exchanges power supply information of the power supply device 200 and the remaining amount information of the battery 214 with the image capture apparatus 100 via the CC communication interface circuit 213. In the present embodiment, the remaining amount information of the battery 214 corresponds to the first remaining amount information related to power that can be supplied from the power supply device 200.

Next, a configuration of the display control unit 300 of the control unit 101 according to the present embodiment will be described with reference to FIG. 3.

Each function of the display control unit 300 is configured by hardware and/or software. When configuring each functional unit illustrated in FIG. 3 by hardware instead of software, a circuit configuration corresponding to each functional unit of FIG. 3 need only be included.

The display control unit 300 includes a serial communication unit 301, a communication standard determination unit 302, a display precision switching unit 303, a remaining amount information calculation unit 304, and a display data generation unit 305.

The serial communication unit 301 is configured by a serial communication circuit such as I2C and is connected to the CC communication interface circuit 203. The serial communication unit 301 obtains the remaining amount information of the battery 214 from the power supply device 200 via the CC communication interface circuit 203.

The communication standard determination unit 302 determines a revision of a communication standard of the CC communication interface circuit 203 via the serial communication unit 301 and determines a reliability of the remaining amount information of the battery 214 based on the revision of the communication standard. The revision of the communication standard can be determined by version information of the communication standard, and the reliability of the remaining amount information of the battery 214 is determined, for example, by referencing a table for evaluating the reliability of the remaining amount information of the battery 214 for each revision of the communication standard, which is stored in the non-volatile memory 103.

The display precision switching unit 303 switches a display precision of the second remaining amount information generated in the display data generation unit 305, which will be described later, according to a result of determination by the communication standard determination unit 302. In the present embodiment, the operable time of the image capture apparatus 100 calculated based on the remaining amount information of the battery 214 corresponds to the second remaining amount information.

In the following, the remaining amount information of the battery 214 of the power supply device 200 will be described as the first remaining amount information, and the operable time of the image capture apparatus 100 calculated based on the remaining amount information of the battery 214 will be described as the second remaining amount information.

The remaining amount information calculation unit 304 calculates the second remaining amount information based on the first remaining amount information obtained from the power supply device 200 by the serial communication unit 301 and a power consumption of the image capture apparatus 100. The display data generation unit 305 generates display data to be outputted to the display unit 105 based on the second remaining amount information calculated by the remaining amount information calculation unit 304.

Next, a method of calculating the second remaining amount information based on the first remaining amount information obtained from the power supply device 200 and the power consumption of the image capture apparatus 100 will be described.

A calculated operable time T [min], which is the second remaining amount information, can be obtained by the following Equation 1 using first remaining amount information C [mAh], a current consumption I [mA] of the image capture apparatus 100, a margin capacitance M [mAh], and a correction coefficient K as parameters.

(Equation 1)

$$T = (C - M) \times K/I \times 60$$

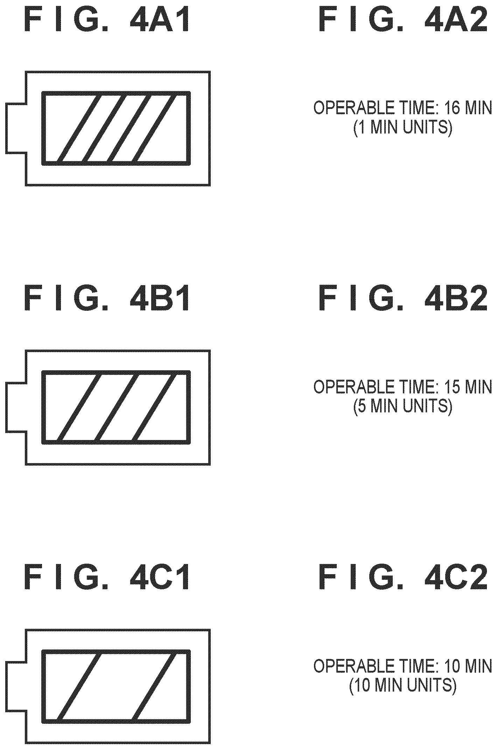

Next, display appearances of the second remaining amount information for which a display precision can be switched according to a reliability of the first remaining amount information according to the present embodiment will be described with reference to FIGS. 4A1, 4A2, 4B1, 4B2, 4C1, and 4C2.

In the present embodiment, regarding the second remaining amount information, a plurality of display appearances are included. The plurality of display appearances include a first display appearance and a second display appearance. The first display appearance is an icon that resembles a shape of a battery as illustrated in FIGS. 4A1, 4B1, and 4C1. The second display appearance is an operable time of the image capture apparatus 100 as illustrated in FIG. 4A2, 4B2, and 4C2.

The first display appearance is displayed in a different form based on the reliability of the first remaining amount information. The different form is the fineness (granularity) of the pattern of an icon in the examples of FIGS. 4A1, 4A2, 4B1, 4B2, 4C1, and 4C2 but may be a form in which gradation, color, and the like is different. In the examples of FIGS. 4A1, 4A2, 4B1, 4B2, 4C1, and 4C2, in the order of FIGS. 4A1, 4B1, and 4C1, the finer the pattern of the icon, the higher the reliability of the first remaining amount information and the more accurate the second remaining amount information. Conversely, the more sparse the pattern of the icon, the lower the reliability of the first remaining amount information, and the less accurate the second remaining amount information.

The second display appearance is displayed by increasing or decreasing a minimum unit time of the operable time based on the reliability of the first remaining amount information. The minimum unit time is a unit time representing the operable time in the example of FIGS. 4A1, 4A2, 4B1, 4B2, 4C1, and 4C2 but may be information indicating other time-based unit. The smaller the minimum unit to be displayed, the higher the reliability of the first remaining amount information, and the more accurate the operable time. Conversely, the greater the minimum unit time, the lower the reliability of the first remaining amount information, and the less accurate the operable time. In the example of FIGS. 4A1, 4A2, 4B1, 4B2, 4C1, and 4C2, a case of FIG. 4A2 where the minimum unit to be displayed is one minute means that the reliability of the first remaining amount information is the highest and the operable time is the most accurate, and a case of FIG. 4C2 where the minimum unit to be displayed is 10 minutes means that the reliability of the first remaining amount information is the lowest and the operable time is the least accurate. In addition, a case of FIG. 4B2 where a minimum unit time is 5 minutes means that the reliability of the first remaining amount information is higher and the operable time is more accurate than the case of FIG. 4C2 where the minimum unit to be displayed is 10 minutes but the reliability of the first remaining amount information is lower and the operable time is less accurate than the case of FIG. 4A2 where the minimum unit to be displayed is one minute.

Thus, by seeing the first display appearance, the user can recognize the precision and reliability of the second remaining amount information of the second display appearance. In the example of FIGS. 4A1, 4A2, 4B1, 4B2, 4C1, and 4C2, examples in which three types of levels can be set as levels of display precision has been described, but a configuration may be taken so as to be able to set three or more types of levels.

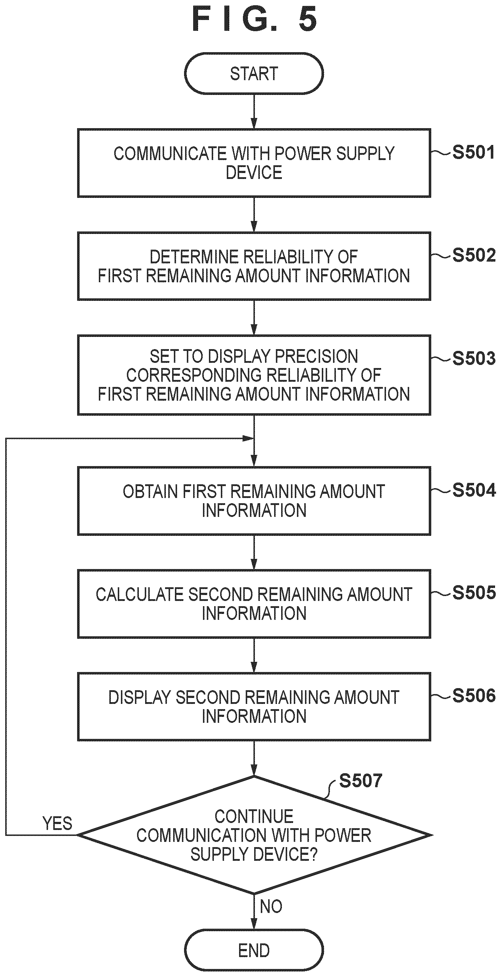

Next, display control processing by the image capture apparatus 100 will be described with reference to FIG. 5.

The processing of FIG. 5 is realized by the control unit 101 functioning as the display control unit 300 by executing a program stored in the non-volatile memory 103 and controlling each component of the image capture apparatus 100. The control unit 101 starts the processing when the image capture apparatus 100 is connected to the power supply device 200, power is turned on, and a system is activated.

In step S501, the serial communication unit 301 starts communication with the power supply device 200 via the CC communication interface circuit 203.

In step S502, the communication standard determination unit 302 determines version information of a standard of communication started in step S501 and, based on a determination result, determines a reliability of the first remaining amount information to be obtained from the power supply device 200. The communication standard determination unit 302 determines that the newer the version information of the communication standard is, the higher the reliability of the first remaining amount information is, for example, by referencing a table for evaluating a reliability of the first remaining amount information for each revision of the communication standard, which is stored in the non-volatile memory 103.

In step S503, the display precision switching unit 303 sets a display precision of the second remaining amount information to be generated by the display data generation unit 305 based on the reliability of the first remaining amount information determined in step S502. The display precision switching unit 303 sets the display precision of the second remaining amount information as the first display appearance and the second display appearance illustrated in FIGS. 4A1, 4A2, 4B1, 4B2, 4C1, and 4C2 based on the reliability of the first remaining amount information determined in step S502.

In step S504, the remaining amount information calculation unit 304 obtains the first remaining amount information from the power supply device 200 via the serial communication unit 301.

In step S505, the remaining amount information calculation unit 304 calculates the second remaining amount information based on the first remaining amount information obtained from the power supply device 200 in step S504.

In step S506, the display data generation unit 305 generates display data based on the second remaining amount information calculated in step S505 and displays the display data on the display unit 105.

In step S507, the control unit 101 determines whether to continue the communication with the power supply device 200 and, when it is determined to continue the communication, returns the processing to step S504 and, when it is determined to not continue the communication, terminates the processing. The control unit 101, when the power of the image capture apparatus 100 is turned off or when a removal of the USB cable is detected, for example, determines to stop the communication and, otherwise, determines to continue the communication.

As described above, according to the present embodiment, a reliability of the first remaining amount information to be obtained from the power supply device 200 is determined according to a revision of a standard of communication between the image capture apparatus 100 and the power supply device 200, and a display precision of the second remaining amount information in the image capture apparatus 100 is switched according to a determination result. This makes it possible for the user to recognize a difference in the reliability of the first remaining amount information obtained from the power supply device and the reliability of the second remaining amount information calculated from the first remaining amount information and perform appropriate preparations, thereby reducing situations such as that in which operation is inadvertently restricted.

The version of the communication standard in step S502 of FIG. 5 may be determined by referencing a unique bit representing a revision of the communication standard or from a storage format of the first remaining amount information or a corresponding command.

Further, the setting of the reliability of the first remaining amount information in step S502 and the display precision of the second remaining amount information in step S502 of FIG. 5 may be determined using a timing at which the revision of the communication standard was released as a reference or determined and set based on a result of determination as to whether it is a particular revision of the communication standard.

Further, a configuration may be taken so as to allow the user to select whether to execute the calculation and display of the second remaining amount information in steps S505 and S506 of FIG. 5 via the operation unit 104.

Further, a configuration may be taken so as to execute the calculation and display of the second remaining amount information in steps S505 and S506 of FIG. 5 only for the first remaining amount information obtained via a general-purpose interface, such as a USB, and not for the remaining amount information of the battery 120 connected via a dedicated interface.

[OTHER EMBODIMENTS]

Embodiment(s) of the present invention can also be realized by a computer of a system or apparatus that reads out and executes computer executable instructions (e.g., one or more programs) recorded on a storage medium (which may also be referred to more fully as a 'non-transitory computer-readable storage medium') to perform the functions of one or more of the above-described embodiment(s) and/or that includes one or more circuits (e.g., application specific integrated circuit (ASIC)) for performing the functions of one or more of the above-described embodiment(s), and by a method performed by the computer of the system or apparatus by, for example, reading out and executing the computer executable instructions from the storage medium to perform the functions of one or more of the above-described embodiment(s) and/or controlling the one or more circuits to perform the functions of one or more of the above-described embodiment(s). The computer may comprise one or more processors (e.g., central processing unit (CPU), micro processing unit (MPU)) and may include a network of separate computers or separate processors to read out and execute the computer executable instructions. The computer executable instructions may be provided to the computer, for example, from a network or the storage medium. The storage medium may include, for example, one or more of a hard disk, a random-access memory (RAM), a read only memory (ROM), a storage of distributed computing systems, an optical disk (such as a compact disc (CD), digital versatile disc (DVD), or Blu-ray Disc (BD)™), a flash memory device, a memory card, and the like.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. An electronic apparatus which operates using power received from a power supply device (200), the apparatus comprising:

   connection means (107) configured to connect with the power supply device; and
   control means (101, 300) configured to obtain first remaining amount information related to power that can be supplied from the power supply device, calculate second remaining amount information related to power by which the electronic apparatus is operable based on the first remaining amount information, and display the second remaining amount information, wherein the control means switches a display precision of the second remaining amount information based on a reliability of the first remaining amount information obtained from the power supply device.

2. The apparatus according to claim 1, further comprising:
   display means (105) configured to display the second remaining amount information.

3. The apparatus according to claim 1, wherein the control means determines the reliability of the first remaining amount information based on a revision of a communication standard according to which communication is performed with the power supply device via the connection means.

4. The apparatus according to claim 3, wherein the revision of the communication standard is determined according to version information of the communication standard.

5. The apparatus according to claim 3, wherein the revision of the communication standard is determined according to data representing the revision of the communication standard.

6. The apparatus according to claim 3, wherein the revision of the communication standard is determined based on a storage format of the first remaining amount information.

7. The apparatus according to claim 4, wherein the control means determines that the newer the version information of the communication standard is, the higher the reliability of the first remaining amount information is.

8. The apparatus according to claim 5, wherein the control means increases the display precision as the reliability of the first remaining amount information increases.

9. The apparatus according to any one of claims 1 to 8, wherein
   the second remaining amount information includes an operable time of the electronic apparatus calculated based on the first remaining amount information.

10. The apparatus according to any one of claims 1 to 9, wherein

    the first remaining amount information is remaining amount information of a battery (214) included in the power supply device,
    the connection means is a general-purpose interface, and
    the control means does not perform calculation and display of the second remaining amount information based on remaining amount information of a battery (120) connected by a dedicated interface.

**11.** The apparatus according to claim 10, wherein

the general-purpose interface conforms to a USB Type-C standard, and communication with the power supply device is CC communication of a USB PD standard.

**12.** A method of controlling an electronic apparatus which includes a connection means (107) configured to connect with a power supply device (200) and operates using power received from the power supply device, the method comprising:

a step (S504) of obtaining first remaining amount information related to power that can be supplied from the power supply device; and

a step (S505) of calculating second remaining amount information related to power by which the electronic apparatus is operable based on the first remaining amount information; and a step (S506) of displaying the second remaining amount information,

wherein a display precision of the second remaining amount information is switched based on a reliability of the first remaining amount information obtained from the power supply device.

**13.** A computer-readable storage medium storing a program for causing a computer to function as an electronic apparatus according to any one of claims 1 to 11.

**14.** A program that causes a computer to function as an electronic apparatus according to any one of claims 1 to 11.

**FIG. 1**

IMAGE CAPTURE APPARATUS

- 104 OPERATION UNIT
- 105 DISPLAY UNIT
- 110 IMAGING UNIT
- 109 LENS
- 101 CONTROL UNIT (CPU)
- 107 CONNECTION UNIT
- 200 POWER SUPPLY DEVICE
- 108 POWER SUPPLY CIRCUIT
- 102 VOLATILE MEMORY
- 103 NON-VOLATILE MEMORY
- 106 RECORDING MEDIUM
- 120 BATTERY
- 100

EP 4 502 759 A1

# FIG. 2

EP 4 502 759 A1

# F I G. 3

EP 4 502 759 A1

F I G. 4A1

F I G. 4A2

OPERABLE TIME: 16 MIN
(1 MIN UNITS)

F I G. 4B1

F I G. 4B2

OPERABLE TIME: 15 MIN
(5 MIN UNITS)

F I G. 4C1

F I G. 4C2

OPERABLE TIME: 10 MIN
(10 MIN UNITS)

# F I G. 5

START

COMMUNICATE WITH POWER SUPPLY DEVICE ~S501

DETERMINE RELIABILITY OF FIRST REMAINING AMOUNT INFORMATION ~S502

SET TO DISPLAY PRECISION CORRESPONDING RELIABILITY OF FIRST REMAINING AMOUNT INFORMATION ~S503

OBTAIN FIRST REMAINING AMOUNT INFORMATION ~S504

CALCULATE SECOND REMAINING AMOUNT INFORMATION ~S505

DISPLAY SECOND REMAINING AMOUNT INFORMATION ~S506

S507

CONTINUE COMMUNICATION WITH POWER SUPPLY DEVICE?

YES

NO

END

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2019/342504 A1 (CANON KK [JP]) 7 November 2019 (2019-11-07) * paragraph [0024] - paragraph [0091]; figures 1-5 * ----- | 1-14 | INV. G06F1/26 |
| A | US 2007/188145 A1 (KIM BUM S [KR] ET AL) 16 August 2007 (2007-08-16) * paragraph [0051] - paragraph [0082]; figures 3-7 * ----- | 1-14 | |
| A | US 2011/178745 A1 (KOBAYASHI KAZUHIDE [JP]) 21 July 2011 (2011-07-21) * paragraph [0037] - paragraph [0174]; figures 1-18 * ----- | 1-14 | |

|  |
|---|
| TECHNICAL FIELDS SEARCHED (IPC) |
| G06F H02J |

The present search report has been drawn up for all claims

| Place of search | Date of completion of the search | Examiner |
|---|---|---|
| Munich | 9 December 2024 | Alonso Nogueiro, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

    .....................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 19 0831

This annex lists the patent family members relating to the patent documents cited in the above-mentioned European search report.
The members are as contained in the European Patent Office EDP file on
The European Patent Office is in no way liable for these particulars which are merely given for the purpose of information.

09-12-2024

| Patent document cited in search report | | | Publication date | Patent family member(s) | | Publication date |
|---|---|---|---|---|---|---|
| US 2019342504 | A1 | | 07-11-2019 | JP | 7140540 B2 | 21-09-2022 |
| | | | | JP | 2019198137 A | 14-11-2019 |
| | | | | US | 2019342504 A1 | 07-11-2019 |
| US 2007188145 | A1 | | 16-08-2007 | CN | 101018255 A | 15-08-2007 |
| | | | | EP | 1819135 A2 | 15-08-2007 |
| | | | | KR | 100656588 B1 | 13-12-2006 |
| | | | | US | 2007188145 A1 | 16-08-2007 |
| US 2011178745 | A1 | | 21-07-2011 | CN | 102159961 A | 17-08-2011 |
| | | | | JP | 5234112 B2 | 10-07-2013 |
| | | | | JP | WO2010032319 A1 | 02-02-2012 |
| | | | | KR | 20110056303 A | 26-05-2011 |
| | | | | US | 2011178745 A1 | 21-07-2011 |
| | | | | WO | 2010032319 A1 | 25-03-2010 |

EPO FORM P0459